# EUROPEAN PATENT APPLICATION

(11) **EP 4 492 461 A1**
(43) Date of publication of application: **15.01.2025**
(21) Application number: 24178721.7
(22) Date of filing: 29.05.2024
(51) Int. Cl.: H01L 25/075, H01L 33/62, H01L 25/16

(54) **DISPLAY DEVICE HAVING PERPENDICULAR ELECTRODE STRUCTURE AND METHOD OF MANUFACTURING THE DISPLAY DEVICE**

(30) Priority: 10.07.2023 KR 20230089049
(71) Applicant: Samsung Electronics Co., Ltd., Suwon-si, Gyeonggi-do 16677 (KR)
(72) Inventor: HWANG, Kyungwook, 16678 Suwon-si (KR); HWANG, Junsik, 16678 Suwon-si (KR); SONG, Sanghoon, 16678 Suwon-si (KR); PARK, Joonyong, 16678 Suwon-si (KR)
(74) Representative: Elkington and Fife LLP

(57) **Abstract**

A display device and a method of manufacturing the display device are provided. The display device includes a display substrate including a driving circuit; an array layer provided on the display substrate and including a plurality of grooves; a micro-semiconductor chip provided in a groove of the plurality of grooves, the micro-semiconductor chip including: an n-type semiconductor layer; an active layer provided on the n-type semiconductor layer; a p-type semiconductor layer provided on the active layer; and a first electrode provided on the p-type semiconductor layer; and a second electrode connected to the n-type semiconductor layer from a lower surface of the display substrate; a first wiring connected to the first electrode; and a second wiring connected to the second electrode.

## Description

### FIELD OF THE INVENTION

The disclosure relates to a display device having a perpendicular electrode structure and a method of manufacturing the display device.

### BACKGROUND OF THE INVENTION

Liquid crystal displays (LCDs), organic light-emitting diode displays (OLEDs), etc. have been widely used as display devices. Recently, technologies that employ micro light-emitting devices to manufacture high-resolution display devices have been receiving attention. Due to the low power-consumption and eco-friendly properties of light-emitting diodes (LEDs), the industrial demand therefor has been growing, and the LEDs have been employed not only in lighting systems or liquid crystal display (LCD) backlights, but also in display devices. In manufacturing a display device using a micro-semiconductor chip, a pick-and-place method has been widely used to transfer micro-semiconductor chips. However, as the size of micro-semiconductor chips is reduced and the size of display devices increases, such a method may result in a decrease in productivity.

A display device including a micro-semiconductor chip requires diverse technologies such as a transfer technology to transfer a micro-sized light-emitting device to a desired display pixel position, a repair process, a method of implementing a desired color, etc.

### SUMMARY OF THE INVENTION

Provided are a display device having a perpendicular electrode structure and a method of manufacturing the display device having the perpendicular electrode structure.

According to an aspect of an embodiment, a display device includes: a display substrate including a driving circuit; an array layer provided on the display substrate and including a plurality of grooves; a micro-semiconductor chip provided in a groove of the plurality of grooves, the micro-semiconductor chip including: an n-type semiconductor layer; an active layer provided on the n-type semiconductor layer; a p-type semiconductor layer provided on the active layer; and a first electrode provided on the p-type semiconductor layer; and a second electrode connected to the n-type semiconductor layer from a lower surface of the display substrate; a first wiring connected to the first electrode; and a second wiring connected to the second electrode.

The display device may further include a plurality of micro-semiconductor chips, and at least one micro-semiconductor chip of the plurality of micro-semiconductor chips is provided in each of the plurality of grooves.

The display substrate may further include a via hole through which the micro-semiconductor chip is exposed, and the second electrode is provided in the via hole.

The display device may further include a reflective layer provided on a sidewall of each of the plurality of grooves.

The first wiring may face away from the second electrode.

The first wiring may be configured to not contact the second electrode in a case where the micro-semiconductor chip is omitted from one of the plurality of grooves.

In a plan view, the first wiring may have a shape including a concave portion and the second electrode is provided in the concave portion.

The first wiring and the second electrode may be positioned in parallel in a plan view.

The display device may further include an insulating layer is on the array layer, and a maximum thickness of the insulating layer is greater than a thickness of the array layer.

The display device may further include a color conversion layer provided on the array layer and configured to convert a color of light emitted from the micro-semiconductor chip.

According to an aspect of the disclosure, a method of manufacturing a display device that includes a micro-semiconductor chip including an n-type semiconductor layer, an active layer provided on the n-type semiconductor layer, a p-type semiconductor layer provided on the active layer, and a first electrode provided on the p-type semiconductor layer, the method including: forming an array layer on a display substrate that may include a driving circuit; forming a plurality of grooves in the array layer; transferring the micro-semiconductor chip to one of the plurality of grooves so that the first electrode is positioned in an upper portion of the one of the plurality of grooves; exposing the n-type semiconductor layer of the micro-semiconductor chip by forming a via hole in the display substrate from a lower surface of the display substrate; forming a second electrode in the via hole and connecting the second electrode to the n-type semiconductor layer; and connecting a first wiring to the first electrode and connecting a second wiring to the second electrode.

The transferring the micro-semiconductor chip includes transferring at least two micro-semiconductor chips to each of the plurality of grooves.

The micro-semiconductor chip may be transferred by using a wet self-alignment method.

The method may further include forming a reflective layer on a sidewall of each of the plurality of grooves.

The first wiring may not overlap with the second electrode.

The first wiring may be configured not to contact the second electrode in a case where the micro-semiconductor chip is omitted from the one of the plurality of grooves.

In a plan view, the first wiring may have a shape including a concave portion and the second electrode is in the concave portion.

The first wiring and the second electrode may be positioned in parallel in a plan view.

The method may further include forming an insulating layer is on the array layer, and a maximum thickness of the insulating layer may be greater than a thickness of the array layer.

The method may further include forming a color conversion layer on the array layer, the color conversion layer being configured to convert a color of light emitted from the micro-semiconductor chip.

Additional aspects will be set forth in part in the description which follows and, in part, will be apparent from the description, or may be learned by practice of the presented non-limiting example embodiments of the present disclosure.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a diagram illustrating a display device having a perpendicular electrode structure, according to an embodiment;
FIG. 2A is a diagram illustrating a display device having a perpendicular electrode structure, according to an embodiment;
FIG. 2B, 2C, 2D, and 2E are diagrams illustrating various examples of an electrode arrangement structure in a display device having a perpendicular electrode structure, according to embodiments;
FIG. 3 is a diagram illustrating a display device having a perpendicular electrode structure, according to an embodiment;
FIG. 4 is a diagram illustrating a case in which a micro-semiconductor chip is omitted from a display device according to an embodiment;
FIGS. 5 and 6 are diagrams illustrating arrangement relationships between electrodes and wirings in a display device according to embodiments;
FIG. 7 is a diagram illustrating an example in which a color conversion layer is provided in a display device having a perpendicular electrode structure, according to an embodiment;
FIGS. 8 to 12 are diagrams illustrating a method of manufacturing a display device, according to an embodiment;
FIG. 13 is a schematic block diagram of an electronic device according to an embodiment;
FIG. 14 is a diagram illustrating an example in which a display device according to an embodiment is applied to a mobile device;
FIG. 15 is a diagram illustrating an example in which a display device according to an embodiment is applied to a display device for vehicles;
FIG. 16 is a diagram illustrating an example in which a display device according to an embodiment is applied to augmented reality glasses;
FIG. 17 is a diagram illustrating an example in which a display device according to an embodiment is applied to signage; and
FIG. 18 is a diagram illustrating an example in which a display device according to an embodiment is applied to a wearable display.

### DETAILED DESCRIPTION

Reference will now be made in detail to embodiments of the present disclosure, examples of which are illustrated in the accompanying drawings, wherein like reference numerals refer to like elements throughout. In this regard, the embodiments of the present disclosure may have different forms and should not be construed as being limited to the descriptions set forth herein. Accordingly, the embodiments described below, by referring to the figures, are provided to explain non-limiting example aspects of the present disclosure. As used herein, the term "and/or" includes any and all combinations of one or more of the associated listed items. Expressions such as "at least one of," when preceding a list of elements, modify the entire list of elements and do not modify the individual elements of the list.

Hereinafter, a display device having a perpendicular electrode structure and a method of manufacturing the display device according to some embodiments are described in detail with reference to the attached drawings. In the drawings, the sizes of components in the drawings may be exaggerated for clarity and convenience of explanation. While such terms as "first," "second," etc., may be used to describe various components, such components must not be limited to the above terms. The above terms are used only to distinguish one component from another

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In the following embodiments, materials constituting each layer are provided merely as an example, and other materials may also be used.

Moreover, the terms "part," "module," etc. refer to a unit processing at least one function or operation, and may be implemented by a hardware, a software, or a combination thereof.

The particular implementations shown and described herein are illustrative examples of embodiments and are not intended to otherwise limit the scope of embodiments in any way. For the sake of brevity, conventional electronics, control systems, software development and other functional aspects of the systems may not be described in detail. Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of the terms "a" and "an" and "the" and similar referents are to be construed to cover both the singular and the plural.

Also, operations of all methods described herein may be performed in any suitable order unless otherwise indicated herein or otherwise clearly contradicted by context. The use of any and all exemplary languages (e.g., "such as") provided herein, are intended merely to better illuminate the technical ideas and does not pose a limitation on the scope of rights unless otherwise stated.

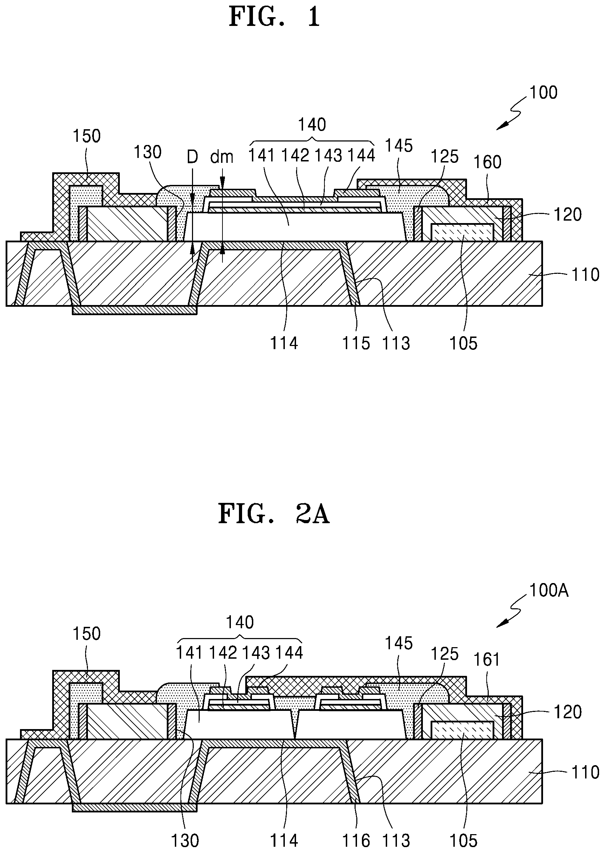

FIG. 1 is a diagram of a display device according to an embodiment.

A display device 100 includes a display substrate 110 including a driving circuit 105, an array layer 120 provided on the display substrate 110, and a micro-semiconductor chip 140 provided on the array layer 120.

The display substrate 110 may include the driving circuit 105 (also referred to as a "driving device") driving the micro-semiconductor chip 140, and the driving circuit 105 may include at least one capacitor and at least one transistor. The display substrate 110 may be a silicon substrate or a glass substrate.

The array layer 120 may include a plurality of grooves 130. The plurality of grooves 130 may be arranged in a matrix structure.

The micro-semiconductor chip 140 may include various types of micro-semiconductor chips having a micro size, and the micro size may be 1000 *µ*m or less or 200 *µ*m or less. The micro-semiconductor chip 140 may include, for example, a light-emitting diode (LED), a complementary metal-oxide semiconductor (CMOS), a CMOS image sensor (CIS), a vertical-cavity surface-emitting laser (VCSEL), a photo diode (PD), a memory device, a two-dimensional (2D) material device, etc. The two-dimensional (2D) material may be graphene or carbon nano tube (CNT).

The micro-semiconductor chip 140 may include a first type semiconductor layer 141, an active layer 142 provided on the first type semiconductor layer 141, a second type semiconductor layer 143 provided on the active layer 142, and a first electrode 144 provided on the second type semiconductor layer 143.

The first type semiconductor layer 141 may be an n-type semiconductor layer. The first type semiconductor layer 141 may include an III-V group n-type semiconductor, for example, n-GaN. The first type semiconductor layer 141 may have a single layer structure or a multi-layer structure.

The active layer 142 may be provided on an upper surface of the first type semiconductor layer 141. When an electron and a hole are coupled, the active layer 142 may generate light. The active layer 142 may have a multi-quantum well (MQW) structure, or a single-quantum well (SQW) structure. The active layer 142 may include an III-V group semiconductor, for example, GaN.

The second type semiconductor layer 143 may be provided on an upper surface of the active layer 142. The second type semiconductor layer 143 may be, for example, a p-type semiconductor layer. The second type semiconductor layer 143 may include an III-V group p-type semiconductor, for example, p-GaN. The second type semiconductor layer 143 may have a single layer structure or a multi-layer structure. Alternatively, when the first type semiconductor layer 141 is a p-type semiconductor layer, the second type semiconductor layer 143 may be an n-type semiconductor layer.

A via hole 113 may be provided in the display substrate 110, and a second electrode 115 may be provided in the via hole 113 so that the second electrode 115 may be connected to the first type semiconductor layer 141. The via hole 113 may penetrate the display substrate 110 so that the first type semiconductor layer 141 is exposed. An upper opening 114 of the via hole 113 may expose the first type semiconductor layer 141. When the via hole 113 is formed, the size of the upper opening 114 of the via hole 113 may be smaller than the cross-sectional size of the micro-semiconductor chip 140 to prevent the micro-semiconductor chip 140 from falling down through the via hole 1130.

The micro-semiconductor chip 140 has a perpendicular electrode structure, and the perpendicular electrode structure of the micro-semiconductor chip 140 may be formed without a wafer bonding process by connecting the second electrode 115 to the first type semiconductor layer 141 through the via hole 113 penetrating from a lower surface of the display substrate 110. A first wiring 160 may be connected to the first electrode 144, and a second wiring 150 may be connected to the second electrode 115.

A reflective layer 125 may be provided on a sidewall of the grooves 130. The reflective layer 125 may include a metal having high reflectivity. The reflective layer 125 may reflect light emitted in a lateral direction of the micro-semiconductor chip 140 and allow the light to travel upward, thereby increasing light emission efficiency. The grooves 130 may have a depth D less than a maximum thickness dm of the micro-semiconductor chip 140. Also, an insulating layer 145 may be provided on the array layer 120. The insulating layer 145 may include resin, SiO₂, SiN, or TiO₂.

In FIG. 1, an example in which one micro-semiconductor chip 140 is provided in one of the grooves 130 has been described, but FIG. 2A illustrates an example in which a plurality of micro-semiconductor chips 140 are provided in one of the grooves 130. For example, two micro-semiconductor chips 140 may be provided in the groove 130. When a plurality of micro-semiconductor chips 140 are provided in the groove 130, even if one micro-semiconductor chip 140 is omitted, the display device 100 may normally operate by the remaining micro-semiconductor chips 140 without a repair process. The components of FIG. 2A using the same reference numerals as those in FIG. 1 have substantially the same functions and configurations, and thus, repeated descriptions thereof may be omitted.

Referring to FIG. 2A, a display device 100A includes the via hole 113 provided in the display substrate 110 and a second electrode 116 provided in the via hole 113. The second electrode 116 may be provided to contact all of the first type semiconductor layers 141 of the two micro-semiconductor chips 140. A part of the second electrode 116 contacting the first type semiconductor layers 141 of the micro-semiconductor chips 140 may be determined by the upper opening 114 of the via hole 113.

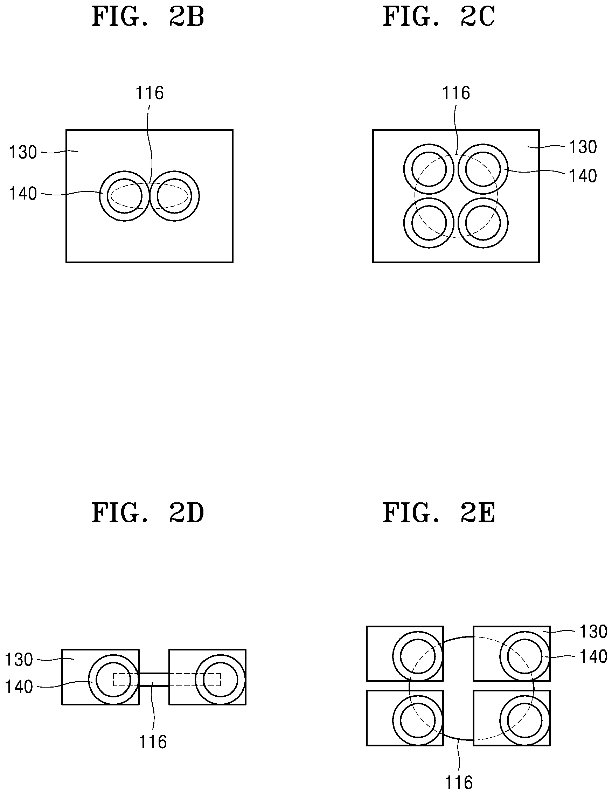

FIG. 2B, 2C, 2D, and 2E illustrate several examples of arrangement relationships between the plurality of micro-semiconductor chips 140 and the second electrode 116 in the upper opening 114 of the via hole 113. The second electrode 116 may be positioned in the upper opening 114 to at least partially overlap each of the first type semiconductor layers 141 of the plurality of micro-semiconductor chips 140.

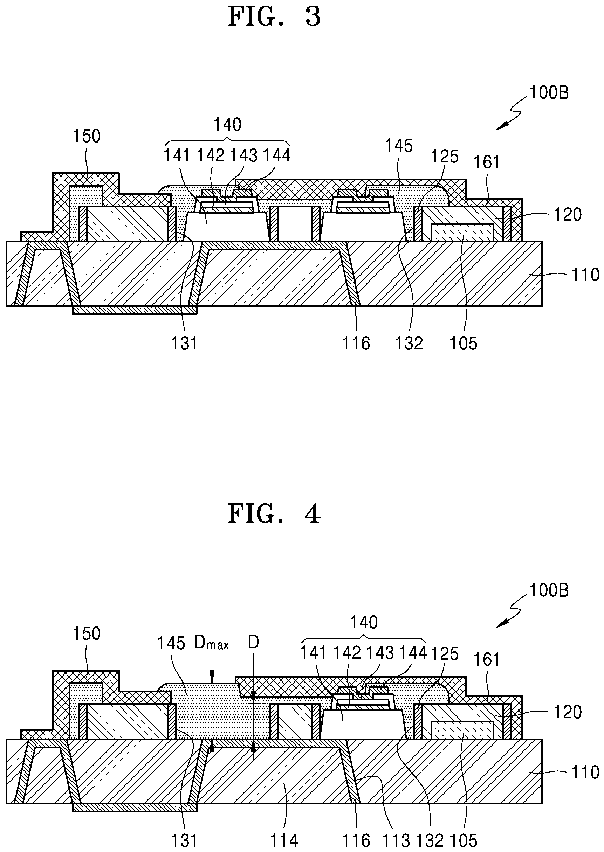

FIG. 3 is different from FIG. 2A in that two micro-semiconductor chips 140 are respectively provided in a first groove 131 and a second groove 132 in a display device 100B. The first groove 131 and the second groove 132 may constitute one sub-pixel. The second electrode 116 provided in the display substrate 110 may contact both the first type semiconductor layer 141 of the micro-semiconductor chip 140 in the first groove 131 and the first type semiconductor layer 141 of the micro-semiconductor chip 140 in the second groove 132. In addition, the first wiring 161 may contact both the first electrode 144 of the micro-semiconductor chip 140 in the first groove 131 and the first electrode 144 of the micro-semiconductor chip 140 in the second groove 132. As described above, the second electrode 116 may be easily connected to the first type semiconductor layer 141 of the micro-semiconductor chip 140 by changing a structure of the via hole 113 according to an arrangement structure of the micro-semiconductor chip 140.

FIG. 4 illustrates a case in which the micro-semiconductor chip 140 is omitted from the first groove 131 in the display device 100B shown in FIG. 3. Even though the micro-semiconductor chip 140 is omitted from the first groove 131, the micro-semiconductor chip 140 in the second groove 132 may operate normally, and thus, the display device 100B may be manufactured without a repair process of the micro-semiconductor chip 140.

Meanwhile, when the micro-semiconductor chip 140 is omitted from the first groove 131 or the second groove 132, the first wiring 161 may be configured to not contact the second electrode 116 to prevent occurrence of an electrical short circuit.

For example, a maximum thickness Dmax of the insulating layer 145 may be greater than a thickness of the array layer 120 or a depth D of the first groove 131. Because the insulating layer 145 is thicker than the array layer 120, when the first wiring 161 is formed by etching the insulating layer 145, the first wiring 161 may be formed only at a certain depth of the insulating layer 145 and may not reach the second electrode 116. Thus, when the micro-semiconductor chip 140 is omitted from the first groove 131, the display device 100B may prevent occurrence of the electrical short circuit by not connecting the first wiring 161 to the second electrode 116.

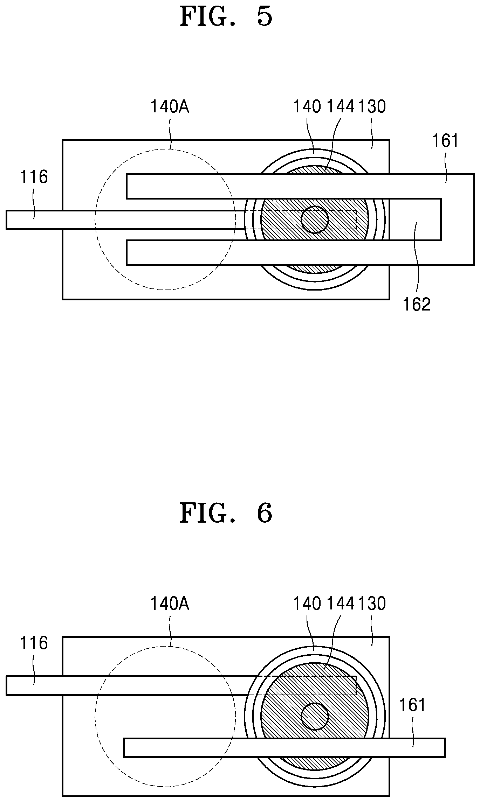

FIG. 5 illustrates another example of an electrode structure for preventing occurrence of an electrical short circuit when a micro-semiconductor chip 140 is omitted. Two micro-semiconductor chips 140 may be transferred to the groove 130. Here, only one micro-semiconductor chip 140 is transferred to the groove 130, and another micro-semiconductor chip 140A may be omitted. FIG. 5 illustrates, for convenience of description, a plan view of the first wiring 161 and the second electrode 116 projected onto the display substrate 110. The first wiring 161 may be disposed not to face the second electrode 116. In other words, when the first wiring 161 and the second electrode 116 are projected onto the display substrate 110, the first wiring 161 may not overlap the second electrode 116. For example, when the first wiring 161 is projected onto the display substrate 110, the first wiring 161 may have a shape including a concave portion 162, and when the second electrode 116 is projected onto the display substrate 110, the second electrode 116 may be disposed in the concave portion 162. The first wiring 161 and the second electrode 116 may be disposed not to overlap each other such that the first wiring 161 contacts the first electrode 144 of the micro-semiconductor chip 140 and the second electrode 116 contacts the first type semiconductor layer 141 of the micro-semiconductor chip 140.

FIG. 6 illustrates another example of an electrode structure for preventing occurrence of an electrical short circuit when a micro-semiconductor chip 140 is omitted. Referring to FIG. 6, when the first wiring 161 and the second electrode 116 are projected onto the display substrate 110, the first wiring 161 and the second electrode 116 may be positioned in parallel.

As described above, the display device 100A and the display device 100B according to an embodiment may normally operate by the remaining micro-semiconductor chips 140 without a repair process even though at least one micro-semiconductor chip 140A is omitted. In addition, the display device 100A and the display device 100B may prevent occurrence of a short circuit at a position where the micro-semiconductor chip 140A is omitted.

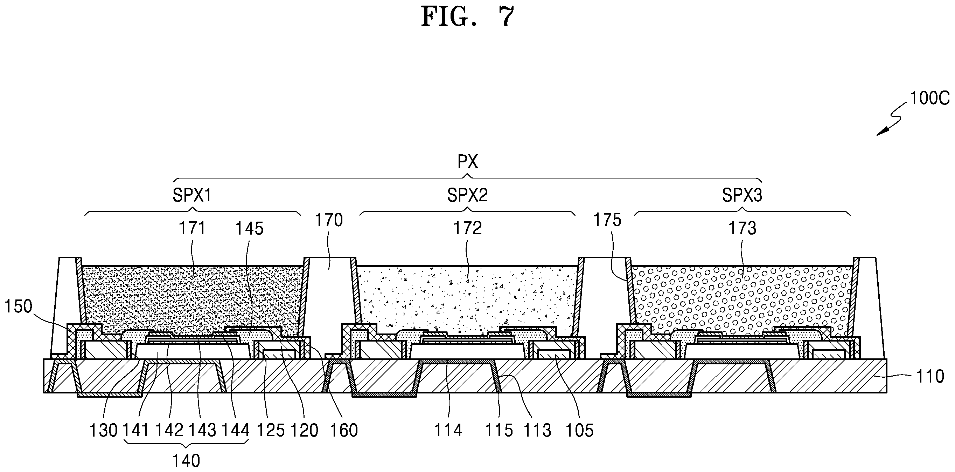

FIG. 7 illustrates a color conversion layer provided in a display device.

FIG. 7 illustrates one pixel PX of a display device 100C, and the pixel PX may include a first sub-pixel SPX1, a second sub-pixel SPX2, and a third sub-pixel SPX3. Barrier ribs 170 may be provided between the first sub-pixel SPX1, the second sub-pixel SPX2, and the third sub-pixel SPX3. A reflective layer 175 may be further provided on the barrier ribs 170.

The color conversion layer may be provided in each of the first sub-pixel SPX1, the second sub-pixel SPX2, and the third sub-pixel SPX3. The color conversion layer may include a first color conversion layer 171 that converts light from the micro-semiconductor chip 140 into a first color light, a second color conversion layer 172 that converts the light into a second color light, and a third color conversion layer 173 that converts the light into a third color light. The micro-semiconductor chip 140 may emit light of a first color, for example, blue light. However, this is only an example and it is possible to emit light of other wavelengths capable of exciting the color conversion layer. The second color light may be, for example, green light, and the third color light may be, for example, red light.

When the micro-semiconductor chip 140 emits the blue light, the first color conversion layer 171 may include a resin that transmits the blue light without light conversion. The second color conversion layer 172 may convert the blue light emitted from the micro-semiconductor chip 140 to emit the green light. The second color conversion layer 172 may include quantum dots (QDs) excited by the blue light and emitting the green light, and the QD may have a core-shell structure including a core part and a shell part, or may have a particle structure without a shell. The core-shell structure may be a single-shell or multi-shell structure, for example, a double-shell structure.

The QD may include an II-VI group semiconductor, an III-V group semiconductor, an IV-VI group semiconductor, an IV group semiconductor, and/or a graphene QD. The QD may include, for example, Cd, Se, Zn, S, and/or InP, and may have a diameter of tens of nm or less, for example, about 10 nm or less. The second color conversion layer 172 may also include a phosphor excited by the blue light emitted from the micro-semiconductor chip 140 and emitting the green light.

The third color conversion layer 173 may convert the blue light emitted from the micro-semiconductor chip 140 into the red light and emit the red light. The third color conversion layer 173 may include QDs of a certain size excited by the blue light and emitting the red light, or may include the phosphor excited by the blue light emitted from the micro-semiconductor chip 140 and emitting the green light. A color image may be displayed through the first color conversion layer 171, the second color conversion layer 172, and the third color conversion layer 173.

According to embodiments of the present disclosure, each of the first sub-pixel SPX1, the second sub-pixel SPX2, and the third sub-pixel SPX3 may include one or more micro-semiconductor chips 140. For example, one or more micro-semiconductor chips 140 may be provided to respectively correspond to each of the first color conversion layer 171, the second color conversion layer 172, and the third color conversion layer 173.

As described above, the display device according to an embodiment may have a perpendicular electrode structure and secure an electrode connection structure that is easy and highly accurate without a bonding transfer. In addition, when a micro-semiconductor chip is omitted from a redundancy structure including a plurality of micro-semiconductor chips in a sub-pixel, the display device may operate normally without a repair process by preventing occurrence of an electrical short circuit.

Next, a method of manufacturing a display device according to an embodiment is described.

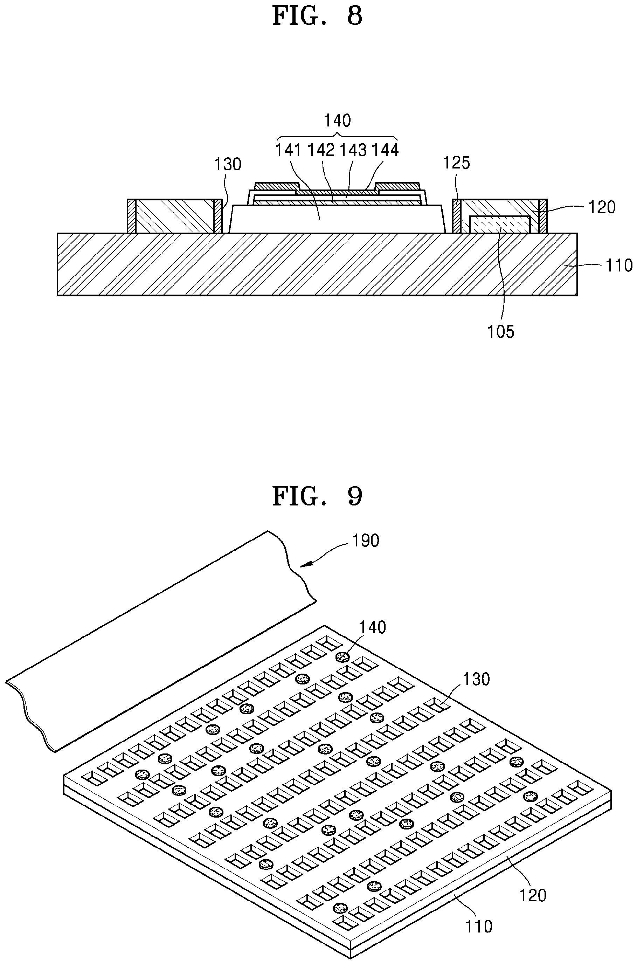

Referring to FIG. 8, the array layer 120 may be formed on the display substrate 110 including the driving circuit 105. The plurality of grooves 130 may be formed in the array layer 120. Here, an example in which the display substrate 110 and the array layer 120 are respectively provided is illustrated, but it is also possible that the display substrate 110 and the array layer 120 are configured as one body. In addition, the reflective layer 125 may be further formed on a sidewall of the groove 130. The micro-semiconductor chip 140 may be transferred to the groove 130.

FIG. 9 is a diagram for explaining a method of transferring the micro-semiconductor chips 140 to the display substrate 110 and the array layer 120.

The micro-semiconductor chips 140 may be transferred to the array layer 120 in various ways. The micro-semiconductor chips 140 may be transferred by using a dry transfer method such as a pick-and-place method or a wet transfer method using liquid.

FIG. 9 illustrates an example of the wet transfer method.

The array layer 120 including the plurality of grooves 130 is formed on the display substrate 110. The grooves 130 may be provided to be locations in which the micro-semiconductor chip 140 may be placed. The micro-semiconductor chip 140 may include, for example, an LED, a CMOS, a CIS, a VCSEL, a PD, a memory device, a 2D material device, etc. The 2D material may be graphene or CNT.

Liquid may be provided to the grooves 130. Any kind of liquid that does not corrode or damage the micro-semiconductor chip 140 may be used. The liquid may include, for example, one or more combinations selected from a group consisting of water, ethanol, alcohol, polyol, keton, halocarbon, acetone, flux, and organic solvent. The organic solvent may include, for example, isopropyl alcohol (IPA). The kind of liquid is not limited thereto, and may be changed in various ways.

A method of providing liquid to the grooves 130 may include, for example, a spray method, a dispensing method, an inkjet dot method, a method of flowing liquid to the array layer 120, etc. The amount of liquid supply may be adjusted in various ways to exactly fill or overfill the grooves 130.

A plurality of micro-semiconductor chips 140 may be provided to the array layer 120. The micro-semiconductor chip 140 may be sprayed to the array layer 120 without other liquids, or may be supplied in a suspension. A method of providing the micro-semiconductor chips 140 included in the suspension may include, for example, a spray method, a dispensing method, by which liquid is provided dropwise, an inkjet dot method, by which liquid is discharged like a printing method, a method of flowing the suspension to the array layer 120, etc.

By contacting and scanning the array layer 120 by using a wiper 190, the micro-semiconductor chips 140 may be transferred to the grooves 130. The micro-semiconductor chips 140 may be transferred such that the first electrode 144 of FIG. 1 is directed towards upper portions of the grooves 130. When the micro-semiconductor chips 140 are transferred, the first electrode 144 may be directed towards the upper portions of the grooves 130 due to an interaction with a difference in surface energy between a side with and a side without the first electrode 144 and the liquid.

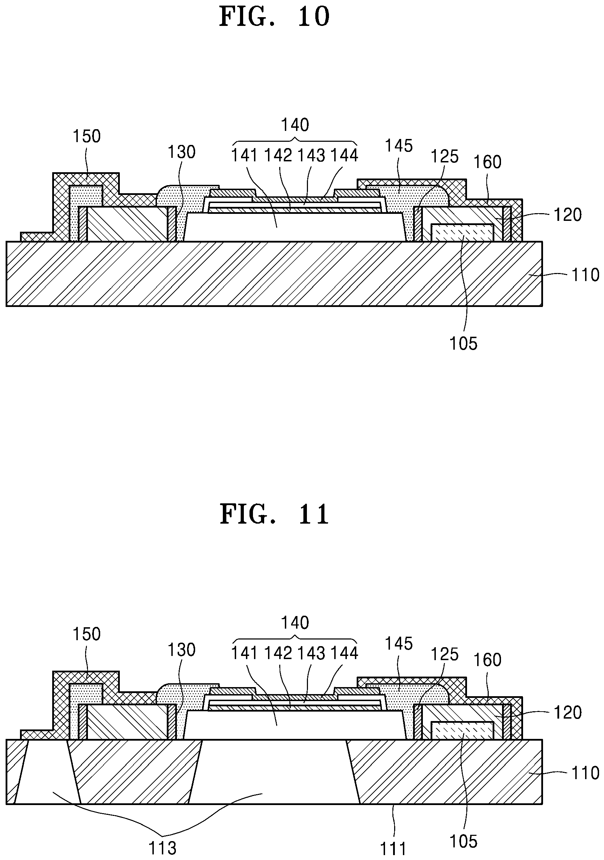

Referring to FIG. 10, an insulating layer 145 may be formed on the array layer 120. The insulating layer 145 may be formed thicker than the thickness of the array layer 120. Alternatively, the insulating layer 145 may be thinly formed on the array layer 120 as a passivation film. The insulating layer 145 may be patterned to form the first wiring 160 and the second wiring 150. The first wiring 160 may be connected to the first electrode 144 of the micro-semiconductor chip 140.

Referring to FIG. 11, the via hole 113 may be formed from a lower surface 111 of the display substrate 110. The via hole 113 may penetrate the display substrate 110 so that the first type semiconductor layer 141 of the micro-semiconductor chip 140 is exposed.

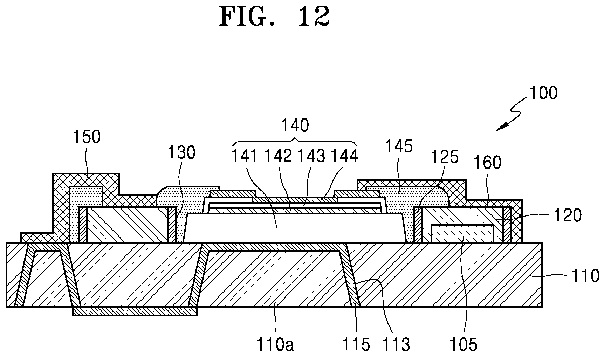

Referring to FIG. 12, the second electrode 115 may be formed in the via hole 113 so that the second electrode 115 may be connected to the first type semiconductor layer 141. Also, the second wiring 150 may be connected to the other side of the second electrode 115. Then, the via hole 113 may be filled with a material 110a that is the same as a material of the display substrate 110.

As described above, in the method of manufacturing the display device according to an embodiment, a bonding transfer process may be omitted by transferring the micro-semiconductor chips 140 having the perpendicular electrode structure to the display substrate 110, and an electrical connection may be easily performed to the perpendicular electrode structure by forming the second electrode 115 in the via hole 113 penetrating the display substrate 110.

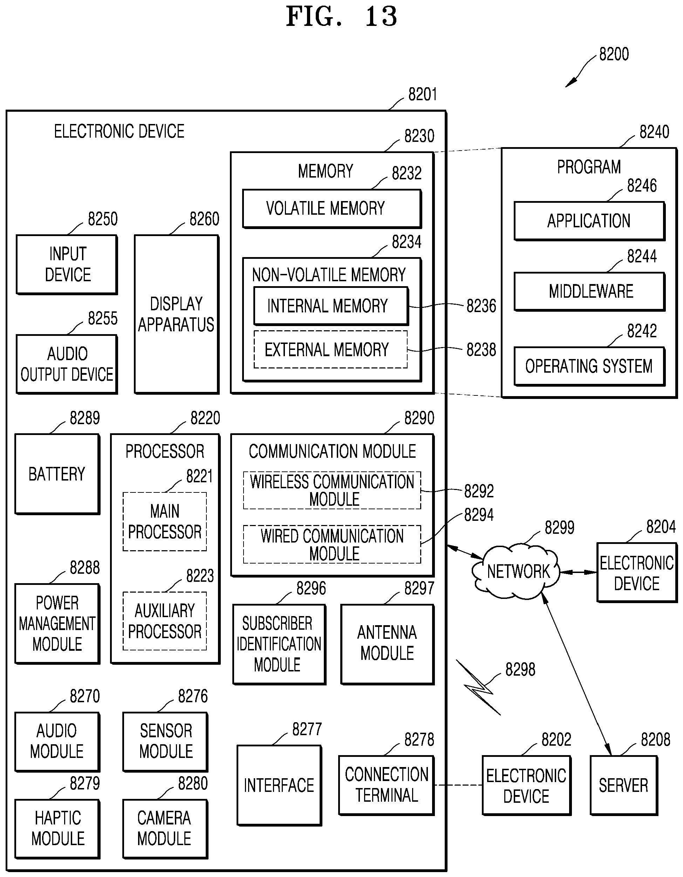

FIG. 13 is a block diagram of an electronic device including a display device according to an embodiment.

Referring to FIG. 13, an electronic device 8201 may be provided in a network environment 8200. In the network environment 8200, the electronic device 8201 may communicate with another electronic device 8202 through a first network 8298 (e.g., a short-range wireless communication network, etc.) or communicate with another electronic device (e.g., an external electronic device 8204) and/or a server 8208 through a second network 8299 (e.g., a long-distance wireless communication network, etc.) The electronic device 8201 may communicate with the external electronic device 8204 through the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of components may be omitted or other components may be added. Some of the components may be implemented by one integrated circuit. For example, the sensor module 8276 (e.g., a fingerprint sensor, an iris sensor, an illuminance sensor, etc.) may be implemented by being embedded in the display device 8260 (a display, etc.)

The processor 8220 may control one or a plurality of other components (e.g., hardware and software components, etc.) of the electronic device 8201 connected to the processor 8220 by executing software (e.g., a program 8240, etc.), and perform various data processing or calculations. As part of the data processing or calculations, the processor 8220 may load, in a volatile memory 8232, commands and/or data received from other components (e.g., the sensor module 8276, the communication module 8290, etc.), process the command and/or data stored in the volatile memory 8232, and store result data in a non-volatile memory 8234. The non-volatile memory 8234 may include an internal memory 8236 and an external memory 8238. The processor 8220 may include a main processor 8221 (e.g., a central processing unit, an application processor, etc.) and an auxiliary processor 8223 (e.g., a graphics processing unit, an image signal processor, a sensor hub processor, a communication processor, etc.) that is operable independently of or together with the main processor 8221. The auxiliary processor 8223 may use less power than the main processor 8221 and may perform a specialized function.

Instead of the main processor 8221 when the main processor 8221 is in an inactive state (sleep state), or with the main processor 8221 when the main processor 8221 is in an active state (application execution state), the auxiliary processor 8223 may control functions and/or states related to some components (e.g., the display device 8260, the sensor module 8276, the communication module 8290, etc.) of the components of the electronic device 8201. The auxiliary processor 8223 (e.g., an image signal processor, a communication processor, etc.) may be implemented as a part of functionally related other components (the camera module 8280, the communication module 8290, etc.)

The memory 8230 may store various data needed by the components (e.g., the processor 8220, the sensor module 8276, etc.) of the electronic device 8201. The data may include, for example, software (the program 8240, etc.) and input data and/or output data of commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input device 8250 may receive commands and/or data to be used for components (the processor 8220, etc.) of the electronic device 8201, from the outside (a user, etc.) of the electronic device 8201. The input device 8250 may include a remote controller, a microphone, a mouse, a keyboard, and/or a digital pen (a stylus pen, etc.)

The audio output device 8255 may output an audio signal to the outside of the electronic device 8201. The audio output device 8255 may include a speaker and/or a receiver. The speaker may be used for general purposes such as multimedia playback or recording playback, and the receiver may be used to receive incoming calls. The receiver may be implemented by being coupled as a part of the speaker or by an independent separate device.

The display device 8260 may visually provide information to the outside of the electronic device 8201. The display device 8260 may include a display, a hologram device, or a projector, and a control circuit to control a corresponding device. The display device 8260 may include the display device according to an embodiment. The display device 8260 may include a touch circuitry set to detect a touch and/or a sensor circuit (a pressure sensor, etc.) set to measure the strength of a force generated by the touch.

The audio module 8270 may convert sound into electrical signals or reversely electrical signals into sound. The audio module 8270 may obtain sound through the input device 8250, or output sound through a speaker and/or a headphone of another electronic device (the electronic device 8202, etc.) directly or wirelessly connected to the audio output device 8255 and/or the electronic device 8201.

The sensor module 8276 may detect an operation state (power, temperature, etc.) of the electronic device 8201, or an external environment state (a user state, etc.), and generate an electrical signal and/or a data value corresponding to a detected state. The sensor module 8276 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface 8277 may support one or more specified protocols used for the electronic device 8201 to be directly or wirelessly connected to another electronic device (the electronic device 8202, etc.) The interface 8277 may include a high-definition multimedia interface (HDMI), a universal serial bus (USB) interface, an SD card interface, and/or an audio interface.

A connection terminal 8278 may include a connector for the electronic device 8201 to be physically connected to another electronic device (the electronic device 8202, etc.) The connection terminal 8278 may include an HDMI connector, a USB connector, an SD card connector, and/or an audio connector (a headphone connector, etc.)

The haptic module 8279 may convert electrical signals into mechanical stimuli (vibrations, movements, etc.) or electrical stimuli that are perceivable by a user through tactile or motor sensations. The haptic module 8279 may include a motor, a piezoelectric device, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject that is a target of image capturing.

The power management module 8288 may manage power supplied to the electronic device 8201. The power management module 8288 may be implemented as a part of a power management integrated circuit (PMIC).

The battery 8289 may supply power to the components of the electronic device 8201. The battery 8289 may include non-rechargeable primary cells, rechargeable secondary cells, and/or fuel cells.

The communication module 8290 may establish a wired communication channel and/or a wireless communication channel between the electronic device 8201 and another electronic device (the electronic device 8202, the external electronic device 8204, the server 8208, and the like), and support a communication through an established communication channel. The communication module 8290 may be operated independent of the processor 8220 (the application processor, etc.), and may include one or more communication processors supporting a direct communication and/or a wireless communication. The communication module 8290 may include a wireless communication module 8292 (a cellular communication module, a short-range wireless communication module, a global navigation satellite system (GNSS) communication module, etc.), and/or a wired communication module 8294 (a local area network (LAN) communication module, a power line communication module, etc.) Among the above communication modules, a corresponding communication module may communicate with another electronic device through the first network 8298 (a short-range communication network such as Bluetooth, WiFi Direct, or infrared data association (IrDA)) or the second network 8299 (a long-range communication network such as a cellular network, the Internet, or a computer network (LAN, WAN, etc.)) These various types of communication modules may be integrated into one component (a single chip, etc.), or may be implemented as a plurality of separate components (multiple chips). The wireless communication module 8292 may verify and authenticate the electronic device 8201 in a communication network such as the first network 8298 and/or the second network 8299 by using subscriber information (an international mobile subscriber identifier (IMSI), and the like) stored in the subscriber identification module 8296.

The antenna module 8297 may transmit signals and/or power to the outside (another electronic device, etc.) or receive signals and/or power from the outside. An antenna may include an emitter formed in a conductive pattern on a substrate (a printed circuit board (PCB), etc.) The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic device through the selected antenna. Other parts (an RFIC, and the like) than the antenna may be included as a part of the antenna module 8297.

Some of the components may be connected to each other through a communication method between peripheral devices (a bus, general purpose input and output (GPIO), a serial peripheral interface (SPI), a mobile industry processor interface (MIPI), etc.) and may mutually exchange signals (command, data, etc.)

The command or data may be transmitted or received between the electronic device 8201 and the external electronic device 8204 through the server 8208 connected to the second network 8299. The electronic device 8202 and the external electronic device 8204 may be of a type that is the same as or different from the electronic device 8201. All or some of operations executed in the electronic device 8201 may be executed in one or more of the other electronic devices (e.g., the electronic device 8202, the external electronic device 8204, and the server 8208). For example, when the electronic device 8201 needs to perform a function or service, the electronic device 8201 may request one or more electronic devices to perform part or the whole of the function or service, instead of performing the function or service. The one or more electronic devices receiving the request may perform additional function or service related to the request, and transmit a result of the performance to the electronic device 8201. To this end, cloud computing, distributed computing, and/or client-server computing technology may be used.

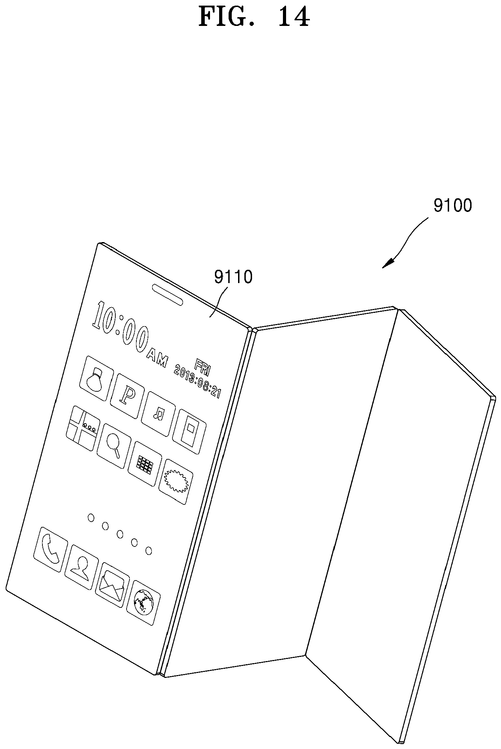

FIG. 14 is a diagram illustrating an example in which a display device according to an embodiment is applied to a mobile device. A mobile device 9100 may include a display device 9110, and the display device 9110 may include the display device according to an embodiment. The display device 9110 may have a foldable structure, for example, a multi-foldable structure.

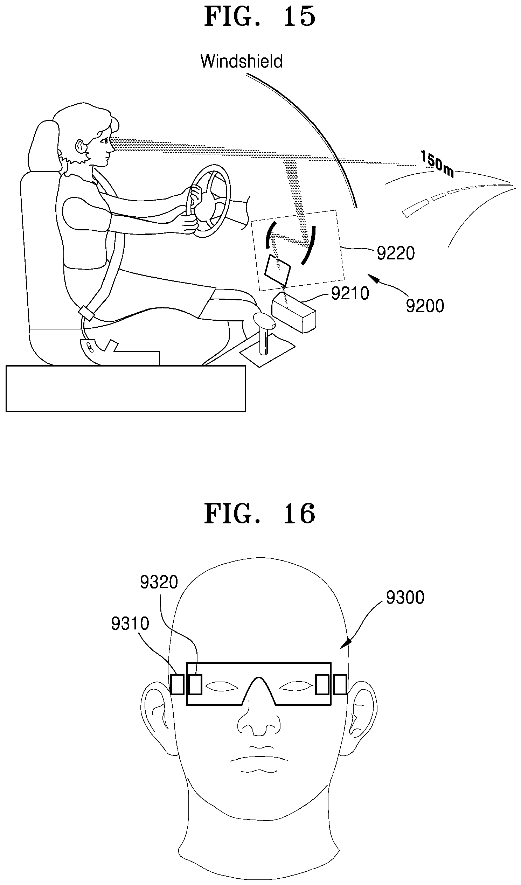

FIG. 15 is a diagram illustrating an example in which a display device according to an embodiment is applied to a display device for vehicles. The display device may be a head-up display device for vehicles 9200 and may include a display 9210 and an optical path change member 9220 configured to change an optical path so that a driver may see an image generated on the display 9210.

FIG. 16 is a diagram illustrating an example in which a display device according to an embodiment is applied to augmented reality glasses. Augmented reality glasses 9300 may include a projection system 9310 configured to form an image, and an element 9320 configured to guide the image from the projection system 9310 to user's eyes. The projection system 9310 may include the display device according to an embodiment.

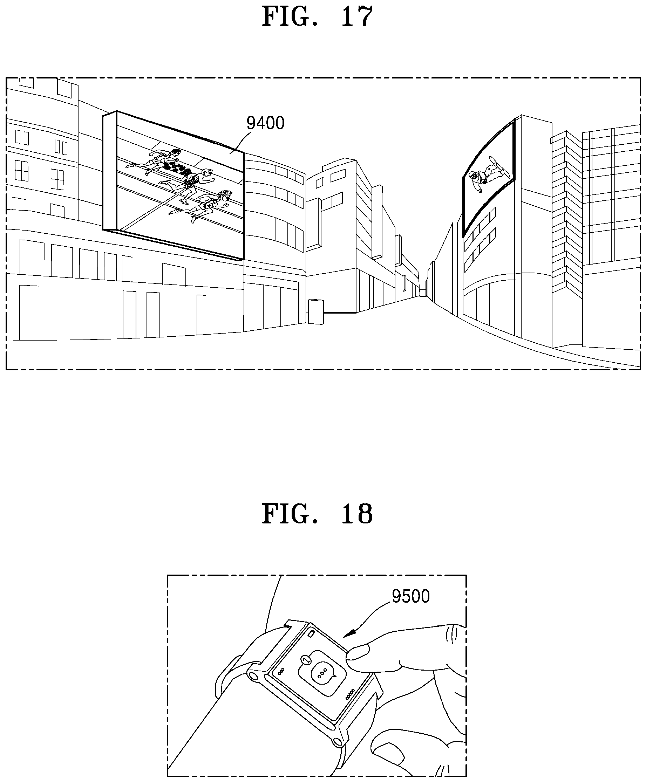

FIG. 17 is a diagram illustrating an example in which a display device according to an embodiment is applied to signage. A signage 9400 may be used in outdoor advertising using a digital information display, and may control contents, etc. of an advertisement though a network. The signage 9400 may be implemented by, for example, the electronic device described with reference to FIG. 13.

FIG. 18 is a diagram illustrating an example in which a display device according to an embodiment is applied to a wearable display. A wearable display 9500 may include the display device according to an embodiment, and may be implemented by the electronic device described with reference to FIG. 13.

The display device according to an embodiment may also be applied to various products such as rollable TV, stretchable display, etc.

A display device according to an embodiment has a perpendicular electrode structure, and has an electrode structure including a via hole in a display substrate and an electrode in the via hole. Also, the display device according to an embodiment may prevent occurrence of a short circuit when a micro-semiconductor chip is omitted.

A method of manufacturing the display device according to an embodiment may provide a method of forming a via hole in a display substrate including a driving circuit and forming an electrode in the via hole.

It should be understood that embodiments described herein should be considered in a descriptive sense only and not for purposes of limitation. Descriptions of features or aspects within each embodiment should typically be considered as available for other similar features or aspects in other embodiments. While one or more non-limiting example embodiments have been described with reference to the figures, it will be understood by those of ordinary skill in the art that various changes in form and details may be made therein without departing from the scope of the present disclosure.

## Claims

1. A display device comprising:
a display substrate comprising a driving circuit;
an array layer provided on the display substrate and comprising a plurality of grooves;
a micro-semiconductor chip provided in a groove of the plurality of grooves, the micro-semiconductor chip comprising:
an n-type semiconductor layer;
an active layer provided on the n-type semiconductor layer;
a p-type semiconductor layer provided on the active layer; and
a first electrode provided on the p-type semiconductor layer; and
a second electrode connected to the n-type semiconductor layer from a lower surface of the display substrate;
a first wiring connected to the first electrode; and
a second wiring connected to the second electrode.

2. The display device of claim 1, wherein two or more micro-semiconductor chips are provided in each of the plurality of grooves.

3. The display device of claim 1 or 2, wherein the display substrate further comprises a via hole through which the micro-semiconductor chip is exposed, and the second electrode is provided in the via hole.

4. The display device of any preceding claim, further comprising a reflective layer provided on a sidewall of each of the plurality of grooves.

5. The display device of any preceding claim, wherein the first wiring faces away from the second electrode.

6. The display device of any preceding claim, wherein the first wiring is configured to not contact the second electrode in a case where the micro-semiconductor chip is omitted from one of the plurality of grooves.

7. The display device of any preceding claim, wherein, in a plan view, the first wiring has a shape comprising a concave portion and the second electrode is provided in the concave portion.

8. The display device of any preceding claim, wherein the first wiring and the second electrode are positioned in parallel in a plan view.

9. The display device of any preceding claim, further comprising an insulating layer is on the array layer,
wherein a maximum thickness of the insulating layer is greater than a thickness of the array layer.

10. The display device of any preceding claim, further comprising a color conversion layer provided on the array layer and configured to convert a color of light emitted from the micro-semiconductor chip.

11. A method of manufacturing a display device that comprises a micro-semiconductor chip comprising an n-type semiconductor layer, an active layer provided on the n-type semiconductor layer, a p-type semiconductor layer provided on the active layer, and a first electrode provided on the p-type semiconductor layer, the method comprising:
forming an array layer on a display substrate that comprises a driving circuit;
forming a plurality of grooves in the array layer;
transferring the micro-semiconductor chip to one of the plurality of grooves so that the first electrode is positioned in an upper portion of the one of the plurality of grooves;
exposing the n-type semiconductor layer of the micro-semiconductor chip by forming a via hole in the display substrate from a lower surface of the display substrate;
forming a second electrode in the via hole and connecting the second electrode to the n-type semiconductor layer; and
connecting a first wiring to the first electrode and connecting a second wiring to the second electrode.

12. The method of claim 11, wherein the micro-semiconductor chip is transferred by using a wet self-alignment method.

13. The method of claim 11 or 12, further comprising forming a reflective layer on a sidewall of each of the plurality of grooves.

14. The method of any of claims 11 to 13, further comprising forming an insulating layer is on the array layer,
wherein a maximum thickness of the insulating layer is greater than a thickness of the array layer.

15. The method of any of claims 11 to 14, further comprising forming a color conversion layer on the array layer, the color conversion layer being configured to convert a color of light emitted from the micro-semiconductor chip.
